# FASCICULE DE BREVET EUROPEEN

(11) **EP 2 725 377 B1**
(45) Date de publication et mention de la délivrance du brevet: **02.08.2017**
(21) Numéro de dépôt: 13188151.8
(22) Date de dépôt: 10.10.2013
(51) Int. Cl.: G01R 33/38, G01R 33/383, G01R 33/387

(54) **Assemblage d'aimants permanents pour un système de RMN avec dispositif de maintien et de réglage desdits aimants permanents**
Dauermagnetanordnung für ein NMR-System mit einem Verfahren zur Aufrechterhaltung und Regulierung der Dauermagneten
Permanent magnet assembly for an NMR system with a device for supporting and adjusting the permanent magnets

(30) Priorité: 23.10.2012 FR 1260061
(43) Date de publication de la demande: 30.04.2014
(73) Titulaire: COMMISSARIAT À L'ÉNERGIE ATOMIQUE ET AUX ÉNERGIES ALTERNATIVES, 75015 Paris (FR)
(72) Inventeur: Cazaux, Sandrine, 91310 MONTLHERY (FR); Branco, Alexandre, 94120 FONTENAY-SOUS-BOIS (FR)
(74) Mandataire: Desormiere, Pierre-Louis

(56) Documents cités:
- WO-A1-2011/023910
- WO-A1-2011/023912
- WO-A1-2011/023913
- US-A- 4 580 098
- US-A- 4 703 276
- US-A- 4 727 327
- US-A- 5 576 679
- US-A1- 2008 204 025
- US-A1- 2009 009 171
- US-A1- 2011 273 254

## Description

### Domaine de l'invention

La présente invention a pour objet un procédé et un dispositif de maintien et de réglage d'aimants permanents inclus dans un système de création de spectres et/ou d'images par résonance magnétique nucléaire (RMN).

L'invention concerne également une structure aimantée appliquée à un appareil de résonance magnétique nucléaire mettant en oeuvre un tel procédé et un tel dispositif de maintien et de réglage d'aimants permanents.

### Art antérieur

La RMN repose sur l'utilisation de champs magnétiques, dont un champ magnétique dit *« principal »* qui doit être aussi uniforme que possible dans la région examinée ou zone d'intérêt ZI. L'usage a consacré le qualificatif « *homogène »* pour désigner ce caractère uniforme. Ce champ magnétique de grande homogénéité est généré par des aimants dont les plus répandus aujourd'hui sont constitués de bobinages supraconducteurs qui transportent les courants électriques générant le champ sans aucune dissipation d'énergie, à condition qu'ils soient maintenus à très basse température. Un tel dispositif d'aimant a généralement l'apparence extérieure d'un tunnel cylindrique dans lequel on introduit l'objet ou le patient à imager.

L'analyse d'échantillons anisotropes, par exemple des solides, par RMN nécessite de faire tourner l'échantillon autour d'un axe orienté à l'angle dit "magique" (arctan(√2) ∼ 54,7).

Les aimants utilisés actuellement en RMN pour créer des champs intenses et homogènes sont, pour la plus grande majorité, basés sur la circulation de courant dans des bobines. Que les bobines soient résistives ou supraconductrices, il y a toujours nécessité d'approvisionner l'aimant en courant et également en fluides cryogéniques dans le cas des bobines supraconductrices. Les appareils sont de ce fait encombrants et difficilement déplaçables. Des bobines résistives nécessitent d'importantes amenées de courant tandis que des bobines supraconductrices impliquent l'utilisation d'un cryostat rempli de liquides cryogéniques, qui est difficile à déplacer.

Une structure basée sur des aimants permanents permet de s'affranchir de ces contraintes puisque le matériau est aimanté une fois pour toutes et, s'il est manipulé de manière appropriée, conserve son aimantation sans maintenance extérieure. Par ailleurs, les matériaux dits permanents sont limités en rémanence (l'aimantation subsistant dans le matériau une fois aimanté) et la génération de champs importants dans de grandes zones utiles nécessite de grandes quantités de matière. La densité de ces matériaux étant d'environ 7.5 g cm⁻³, on aboutit rapidement à des systèmes très lourds. Il est donc important de minimiser la quantité de matériau pour un champ donné.

La difficulté des systèmes magnétiques en matériaux permanents pour la RMN réside dans le besoin de coupler champs intenses avec forte homogénéité. Les procédés de fabrication des matériaux comme le NdFeB ne permettent pas de garantir une parfaite homogénéité d'aimantation, ni une parfaite répétitivité. Aussi, bien qu'il soit possible de calculer des structures fournissant l'homogénéité désirée, il est nécessaire de ménager des possibilités de réglages *a posteriori* qui permettent de corriger les imperfections du matériau.

La forme d'ensemble pour ces structures aimantées est généralement le cylindre, où la structure adopte au moins une symétrie axiale. Ceci permet de s'affranchir de nombreux facteurs d'inhomogénéité. La zone d'intérêt se trouve alors au centre du cylindre et l'accès à cette zone peut se faire selon l'axe en dégageant un trou dans le cylindre, ou alors par le côté en séparant le cylindre en deux.

On a déjà proposé, par exemple dans les documents WO 2011/023912, WO 2011/023910 et WO 2011/023913, des assemblages de structures aimantées coaxiales induisant en leur centre un champ magnétique homogène d'orientation prédéterminée. De tels assemblages sont adaptés pour faire de la RMN portative et à bas coût par exemple sur de petits animaux ou sur des parties du corps. Ils sont également susceptibles de permettre d'observer des zones non observables avec l'imagerie médicale supraconductrice, notamment des zones frontières par exemple entre le cerveau et la boîte crânienne.

Toutefois, de telles structures aimantées ne peuvent fonctionner que grâce à la qualité des aimants permanents et de leur assemblage. Il est donc important de leur adjoindre des possibilités de maintien et de réglage qui permettent de récupérer les défauts géométriques de fabrication des aimants et de la mécanique, mais aussi les défauts magnétiques et des gradients de température. La précision du champ magnétique nécessaire pour l'application en RMN est permise si l'on peut disposer de tels dispositifs de maintien et de réglage jusqu'à un stade avancé, y compris lors de la mise en oeuvre de la structure aimantée.

### Définition et objet de l'invention

La présente invention vise à remédier aux inconvénients précités et à permettre la réalisation de façon simplifiée d'un dispositif de maintien et de réglage d'aimants permanents élémentaires inclus dans un système de spectroscopie ou d'imagerie par résonance magnétique.

L'invention vise plus particulièrement à réaliser, pour un appareil de RMN, une structure aimantée dans laquelle il est possible d'assurer un réglage de la position d'aimants élémentaires après montage de la structure aimantée et ainsi garantir l'obtention d'un champ homogène.

L'invention vise encore à réaliser, pour un appareil de RMN, une structure aimantée compacte, sans balourd, la plus légère possible et dans laquelle les dispositifs de support occupent le moins de place possible.

Ces buts sont atteints, conformément à l'invention, grâce à un dispositif de création d'un champ magnétique principal d'un système de spectroscopie ou d'imagerie par résonance magnétique selon les revendications 1 à 12 annexées.

L'invention a encore pour objet un procédé de création d'un champ magnétique principal d'un système de spectroscopie ou d'imagerie par résonance magnétique selon les revendications 13 et 14 annexées.

### Brève description des dessins

D'autres caractéristiques et avantages de l'invention ressortiront de la description suivante de modes particuliers de réalisation de l'invention donnés à titre d'exemples en référence aux dessins annexés, sur lesquels :
- La Figure 1 représente une vue schématique en perspective d'un exemple de dispositif selon l'invention assurant le maintien et le réglage d'un ensemble d'aimants élémentaires superposés,
- La Figure 2 montre une vue schématique en perspective analogue à la figure 1, mais montrant pour un aimant élémentaire une deuxième fourche qui est déconnectée de la première fourche solidaire de l'aimant élémentaire,
- La Figure 3 est une vue en élévation du dispositif de la figure 1,
- La Figure 4 montre le dispositif de la figure 1 sous une forme éclatée avec un organe de support dissocié des aimants élémentaires et de leurs fourches associées,
- La Figure 5 est une vue en perspective de l'aspect extérieur d'une structure aimantée selon l'invention qui est munie de dispositifs de maintien et de réglage d'aimants élémentaires tels que ceux illustrés sur les figures 1 à 4,
- La Figure 6 est une vue en élévation de la structure aimantée de la figure 5 avec une dissociation des couronnes d'aimants supérieure et inférieure et de la couronne d'aimants intermédiaire munie de dispositifs de maintien et de réglage d'aimants élémentaires,
- La Figure 7 est une demi-coupe axiale de la structure aimantée de la figure 5, qui est en outre équipée d'une enceinte de protection thermique,
- Les Figures 8 et 9 sont des vues respectivement en perspective et en demi-coupe axiale, sans la plaque de protection supérieure, de la couronne d'aimants inférieure de la structure aimantée de la Figure 5,
- Les Figures 10 et 11 sont des vues respectivement en élévation et en perspective d'un exemple de structure aimantée à laquelle est applicable l'invention,
- La Figure 12 montre un exemple d'aimant élémentaire en forme de secteur présentant des bords courbes,
- La Figure 13 montre un exemple d'aimant élémentaire de forme cylindrique, et
- La Figure 14 montre un exemple d'aimant élémentaire de forme parallélépipédique.

### Description détaillée de modes de réalisation préférentiels

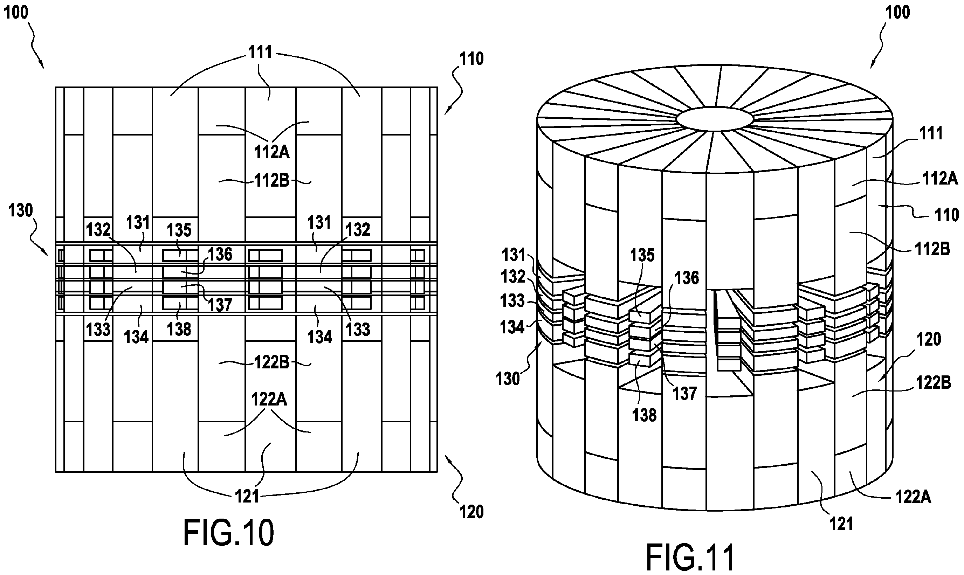

On décrira d'abord en référence aux figures 10 et 11 un exemple de structure aimantée appliquée à un appareil de Résonance Magnétique Nucléaire, à laquelle est applicable l'invention.

Sur les figures 10 et 11, on voit une structure aimantée 100 appliquée à un appareil de Résonance Magnétique Nucléaire, induisant dans une zone d'intérêt centrale un champ magnétique homogène orienté, dans cet exemple, selon un axe orienté à l'angle magique par rapport à un axe longitudinal de la structure.

La structure aimantée 100 comprend des première et deuxième couronnes aimantées 110, 120 disposées de façon symétrique par rapport à un plan qui est perpendiculaire audit axe longitudinal et contient la zone d'intérêt centrale.

Une structure aimantée annulaire médiane 130 est interposée entre les première et deuxième couronnes aimantées 110, 120 et est également disposée de façon symétrique par rapport audit plan, et divisée, selon cet exemple, en quatre tranches selon l'axe longitudinal.

Les première et deuxième couronnes aimantées 110, 120 ainsi que les diverses tranches de la structure aimantée médiane 130 sont divisées chacune en aimants permanents élémentaires.

La couronne aimantée 110 peut par exemple être aimantée radialement par rapport à l'axe longitudinal avec une aimantation divergente tandis que la couronne aimantée 120 est aimantée radialement par rapport à l'axe longitudinal avec une aimantation convergente, la structure aimantée médiane 130 étant aimantée selon l'axe longitudinal de façon à créer une structure hybride, mais l'invention n'est pas limitée à un tel exemple et s'applique à toutes sortes de structures aimantées comportant des aimants permanents élémentaires.

D'une manière générale, il est avantageux de réaliser chaque structure cylindrique annulaire sous la forme d'une structure polyédrique régulière comprenant un ensemble de N segments identiques. Chaque segment est ainsi un prisme droit de section sensiblement trapézoïdale isocèle et son aimantation est parallèle à la hauteur du prisme ou formant un angle prédéterminé par rapport à cette hauteur.

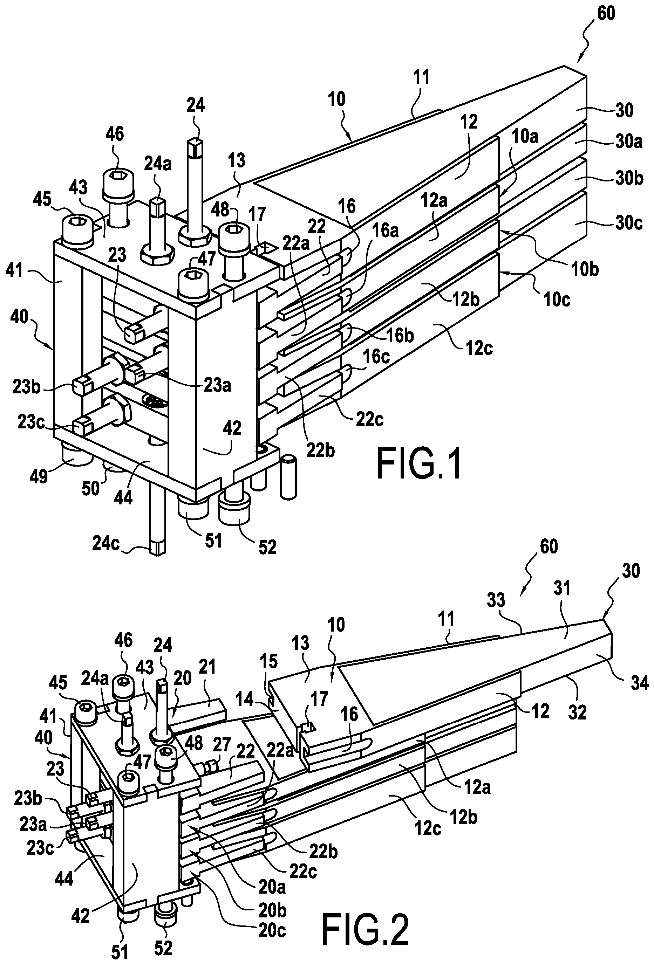

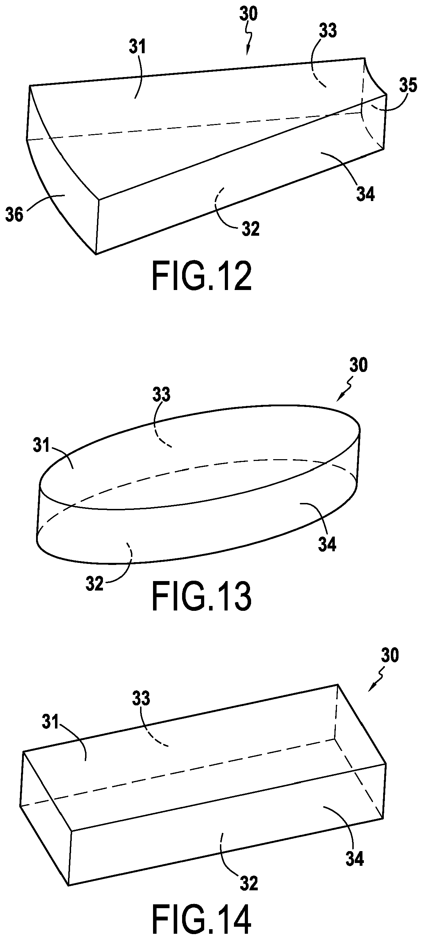

L'invention peut cependant être réalisée avec de nombreuses variantes. Ainsi chaque segment ou aimant permanent élémentaire 30 peut non seulement avoir une forme de trapèze isocèle ou non, comme représenté notamment sur les figures 1 à 4, mais également une forme de trapèze approchée avec des côtés sensiblement parallèles courbes 35, 36, comme représenté sur la figure 12. Chaque segment ou aimant permanent élémentaire 30 peut encore avoir par exemple une forme de cylindre vertical, par exemple à section ovale, comme montré sur la figure 13 ou une forme de parallélépipède, comme représenté sur la figure 14.

De façon plus particulière, les aimants permanents élémentaires des première et deuxième couronnes aimantées 110, 120 sont collés entre eux de façon fixe, mais la structure aimantée comprend des moyens de réglage longitudinal entre les première et deuxième couronnes aimantées 110, 120 et la structure aimantée annulaire médiane 130.

Par ailleurs, chaque segment élémentaire d'une tranche de la structure aimantée médiane 130 est non contigu par rapport aux segments voisins afin de permettre un réglage mécanique après l'assemblage.

Dans l'exemple des figures 10 et 11, on a représenté pour chaque tranche de la structure aimantée médiane 130 une alternance de deux types d'aimants élémentaires en forme de secteurs. Ainsi on a pour la première tranche une alternance d'aimants non jointifs 131 et 135, pour la deuxième tranche une alternance d'aimants non jointifs 132 et 136, pour la troisième tranche une alternance d'aimants non jointifs 133 et 137 et pour la quatrième tranche une alternance d'aimants non jointifs 134 et 138. Les aimants 131 à 134 des différentes tranches sont superposés, de même que les aimants 135 à 138 des différentes tranches.

Dans l'exemple illustré sur les figures 10 et 11, on a représenté pour chaque tranche de la structure aimantée médiane 130 douze aimants élémentaires d'un premier type (par exemple 131, 132, 133 ou 134) qui alternent avec douze aimants élémentaires d'un second type (par exemple 135, 136, 137 ou 138). Toutefois l'invention n'est pas limitée à ces nombres d'aimants élémentaires par tranche.

De même il pourrait également n'être mis en oeuvre, en tant qu'aimants élémentaires non jointifs des tranches de la couronne médiane 130, que le seul premier type d'aimant élémentaire 131 à 134 ou que le seul second type d'aimant élémentaire 135 à 138 et non des aimants élémentaires de deux types différents.

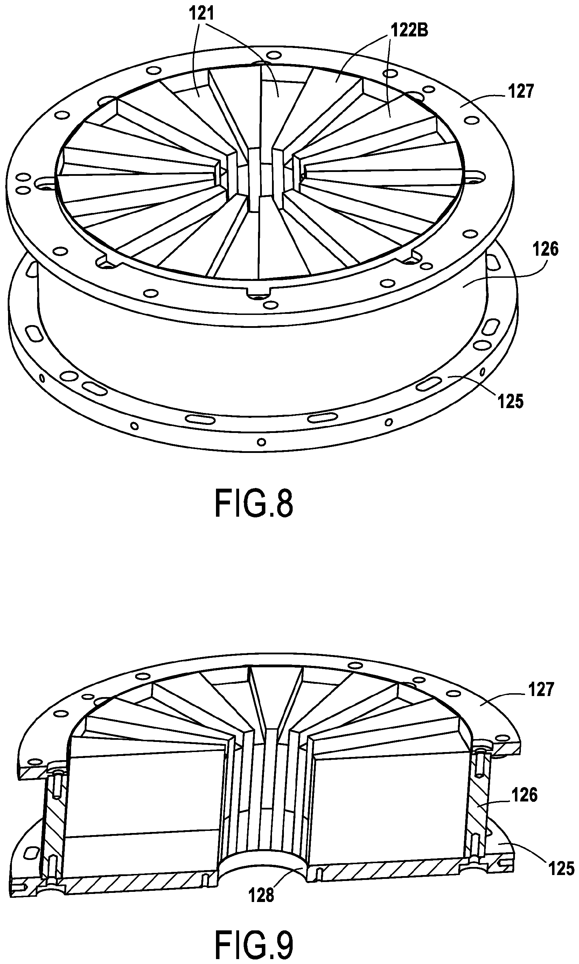

Dans l'exemple des figures 10 et 11, on a pour chacune des couronnes aimantées 110 et 120 d'une part une première série d'aimants élémentaires identiques en forme de secteur 111 respectivement 121 régulièrement répartis et d'autre part une deuxième série de paires d'aimants élémentaires identiques superposés en forme de secteur 112A, 112B respectivement 122A, 122B qui sont disposés en alternance de façon imbriquée avec les aimants élémentaires de la première série 111 respectivement 121, de façon jointive. Par ailleurs, les aimants élémentaires 111, respectivement 121 sont légèrement en retrait par rapport aux aimants élémentaires contigus 112B respectivement 122B, comme représenté également sur les figures 8 et 9, sur le côté intérieur faisant face à la couronne médiane 130. Toutefois, ceci ne constitue qu'un exemple de réalisation particulier et cette configuration n'est pas limitative.

On décrira maintenant en référence aux figures 1 à 6 un exemple de dispositif selon l'invention permettant de maintenir en position et régler radialement et verticalement de façon individuelle et indépendante les aimants élémentaires de la couronne centrale 130, même après l'assemblage de la structure aimantée 100.

Si l'on se réfère aux figures 1 à 4 et plus particulièrement à la figure 2, on voit que chaque aimant permanent élémentaire 30 présente des faces principales 31, 32 en forme de trapèze isocèle inscrit dans un secteur et deux faces latérales allongées 33, 34. Pour chaque aimant permanent élémentaire 30 une première fourche 10 rigide en matériau amagnétique comprend des branches 11, 12 qui pincent latéralement de manière fixe les faces latérales 33, 34 de l'aimant permanent élémentaire 30. Chaque aimant permanent élémentaire 30 est fixé par collage dans la première fourche rigide 10. La première fourche 10 qui saisit les faces latérales 33, 34 de l'aimant élémentaire 30 par ses branches planes 11, 12 est optimisée pour permettre le maximum de surface de collage et ainsi obtenir une meilleure tenue mécanique. La saisie latérale d'un aimant élémentaire 30 permet de réaliser un dispositif de positionnement peu encombrant qui permet de conserver un ensemble d'aimants élémentaires très proches les uns des autres.

Il est à noter qu'il peut exister des dispositifs de RMN mettant en oeuvre des aimants élémentaires de formes différentes de celle représentée sur les figures 1 à 4 et auxquels l'invention est également applicable.

Ainsi, comme représenté sur la figure 12, un aimant élémentaire 30 peut présenter une forme de trapèze approché avec deux côtés courbes opposés 35, 36 et deux côtés latéraux 33, 34 rectilignes.

Comme représenté sur la figure 13, un aimant élémentaire 30 peut présenter une forme de cylindre placé généralement verticalement et pouvant présenter une section de forme quelconque, par exemple ovale.

Comme représenté sur la figure 14, un aimant élémentaire 30 peut encore présenter une forme de parallélépipède.

On notera que dans le cas d'aimants élémentaires 30 par exemple cylindriques, la pince fixe 10 peut présenter des branches 11, 12 qui ne sont pas nécessairement planes et peuvent être plus adaptées à la forme de l'aimant élémentaire 30. Une pince fixe 10 peut ainsi présenter des branches 11, 12 courbes adaptées pour épouser la surface courbe 33, 34 d'un aimant de forme cylindrique (figure 13).

La combinaison de la première fourche 10 avec une deuxième fourche 20 permet d'obtenir un réglage radial de la position de l'aimant avec un système de guidage simple et peu encombrant et qui permet la réversibilité du mouvement.

La deuxième fourche 20 rigide en matériau amagnétique comprend deux bras 21, 22 qui sont en prise avec le corps 13 de la première fourche 10 par un système de glissière. La deuxième fourche 20 est en outre munie de moyens de réglage radial 23 de la position de la première fourche 10 et de l'aimant élémentaire 30 par rapport à un support fixe 40 dans lequel est emprisonnée la deuxième fourche 20.

De façon plus particulière, la première fourche 10 comprend un corps 13 auquel sont rattachées les branches planes 11, 12 qui pincent l'aimant 30. Les parties latérales du corps 13 de la première fourche présentent des rainures 15, 16 (ou à titre de variante des nervures) destinées à coopérer avec des éléments complémentaires (nervures ou rainures) des branches 21, 22 pour former lesdites glissières. Ces glissières permettent un bon maintien de l'aimant 30 malgré les efforts magnétiques importants exercés dans toutes les directions. Les éléments complémentaires (nervure, rainure) des glissières peuvent être composés de matériaux amagnétiques (par exemple du bronze, du titane, un alliage d'aluminium et un alliage d'aluminium et béryllium connu sous la marque déposée « albemet »), afin de limiter les frottements et les déformations dus aux efforts magnétiques.

Les moyens de réglage radial 23 de la première fourche 10 comprennent une tige filetée dont une extrémité 27 est en prise avec une encoche 17 formée dans une partie arrière 14 du corps 13 de la première fourche 10.

Le dispositif de maintien et de réglage selon l'invention est peu encombrant et compatible avec le faible espace disponible entre aimants élémentaires adjacents 30 pour conserver une structure d'ensemble compacte et légère. Les première et deuxièmes fourches 10, 20 sont rigides et en matériau amagnétique (par exemple du bronze, du titane, un alliage d'aluminium, un alliage d'aluminium et de béryllium connu sous la marque déposée « albemet ») afin de ne pas perturber les efforts magnétiques et de ne pas provoquer de désaimantation des aimants permanents 30.

La tige filetée 23 en matériau résistant et à pas fin permet des réglages radiaux pouvant aller par exemple de quelques micromètres à quelques millimètres. Le dispositif de maintien et de réglage selon l'invention constitue ainsi un mécanisme de précision tout en présentant la robustesse nécessaire pour résister par exemple aux effets des forces magnétiques en présence et de la force centrifuge lorsque la structure aimantée est en rotation.

Avantageusement, la deuxième fourche rigide 20 est en outre munie de moyens de réglage 24 par rapport au support fixe 40 dans une direction perpendiculaire aux faces principales de l'aimant permanent élémentaire 30 maintenu par la première fourche 10. Ce réglage peut être définitif par exemple au moyen de cales, ou variable, par exemple au moyen de tiges filetées.

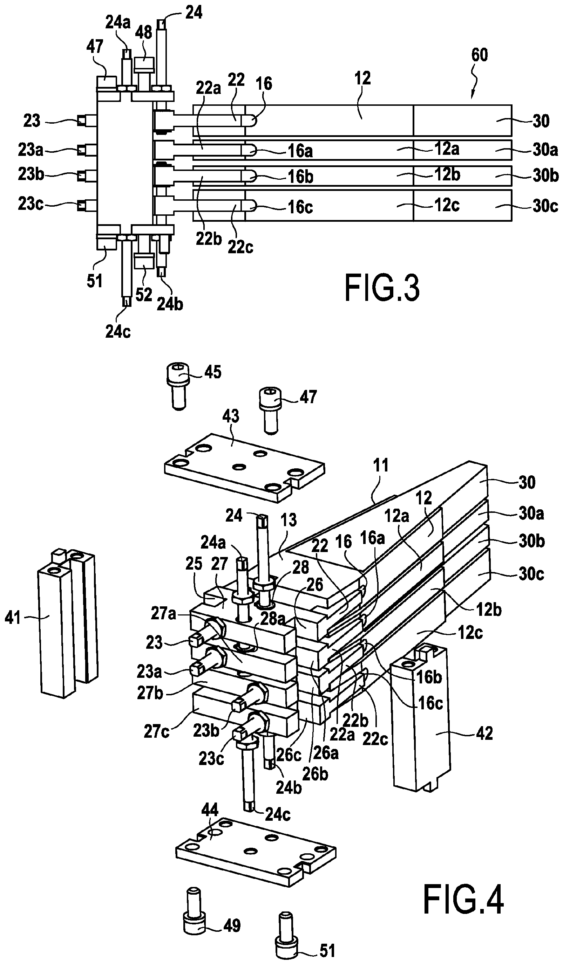

Ainsi, comme on peut le voir sur la figure 4, des encoches ou rainures 25, 26 sont formées de part et d'autre du corps 27 de la deuxième fourche 20, afin de coopérer avec des nervures formées sur les montants 41, 42 du support fixe et permettre un coulissement du corps 27 de la deuxième fourche 20 par rapport au support fixe 40 dans un sens vertical selon la disposition des figures 1 à 4, lorsque l'on agit sur la tige filetée correspondante 24 permettant la commande du déplacement de la deuxième fourche 20 par rapport au support fixe 40.

La vis micrométrique ou tige filetée 24 coopère avec un circlip 28 qui permet la réversibilité du déplacement vertical de la deuxième fourche 20 et donc de l'aimant élémentaire 30. Le blocage du réglage pendant des mesures ou pendant la rotation de la structure aimantée peut être effectué par un simple écrou.

Comme on peut le voir sur les figures 1 à 6, lorsqu'une structure aimantée annulaire médiane comprend plusieurs couches superposées d'aimants élémentaires (par exemple deux ou quatre couches), il est possible d'utiliser un même support fixe 40 pour un ensemble 60 de plusieurs aimants élémentaires superposés appartenant à des couches différentes et munis chacun d'une première fourche 10 et d'une deuxième fourche 20 comme décrit précédemment.

Sur les figures 1 à 4, on a représenté quatre aimants élémentaires superposés 30, 30a, 30b, 30c qui sont identiques et coopèrent chacun avec un dispositif de maintien et de réglage comprenant une première fourche 10, 10a, 10b, 10c et une deuxième fourche 20, 20a, 20b, 20c. Tous les éléments des dispositifs de maintien et de réglage concernant les aimants 30a, 30b, 30c situés sous l'aimant 30 portent les mêmes références que celles des éléments du dispositif de maintien et de réglage concernant l'aimant 30, mais avec respectivement l'adjonction de la lettre a, b ou c, et ne seront pas décrits séparément.

Le support fixe 40 comprend des plaques d'extrémité supérieure 43 et inférieure 44 ainsi que des montants latéraux 41, 42 munis de nervures ou rainures coopérant avec les rainures ou nervures 25,26 ; 25a, 26a ; 25b, 26b ; 25c, 26c des deuxièmes fourches superposées 20, 20a, 20b, 20c. Le support fixe 40 en forme de colonne est muni de pions de positionnement 45 à 48 et 49 à 52 coopérant avec les plaques d'extrémité 43 et 44 respectivement, afin d'obtenir une mécanique de précision et d'augmenter la rigidité afin de résister aux efforts magnétiques qui peuvent être de plusieurs dizaines de newtons.

Afin d'optimiser la commande de réglage vertical des deuxièmes fourches 20, 20a, 20b, 20c, les vis de réglage 24, 24a, 24b, 24c peuvent être réparties par paires, les vis 24 et 24a de commande du réglage vertical des deuxièmes fourches 20 et 20a émergeant à travers la plaque d'extrémité supérieure 43 et les vis 24b et 24c de commande du réglage vertical des deuxièmes fourches 20b et 20c émergeant à travers la plaque d'extrémité inférieure 44. Les vis de commande 24a et 24b traversent simplement les corps 27 et 27c respectivement des deuxièmes fourches d'extrémité 20 et 20c à travers de simples trous. Le réglage vertical des aimants d'un ensemble 60 peut ainsi présenter un encombrement réduit. Le système de réglage permet d'obtenir dans le sens vertical un déplacement des aimants inférieur à 1 mm.

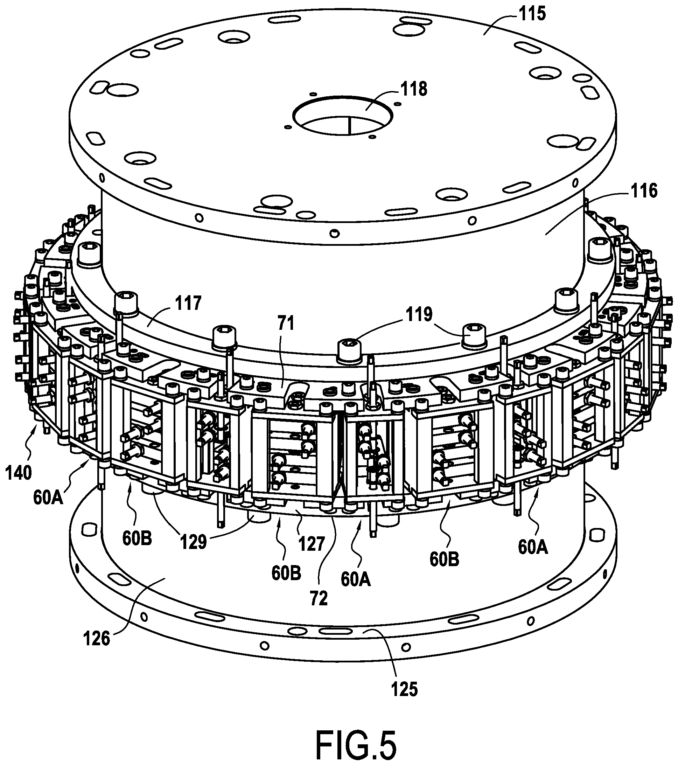

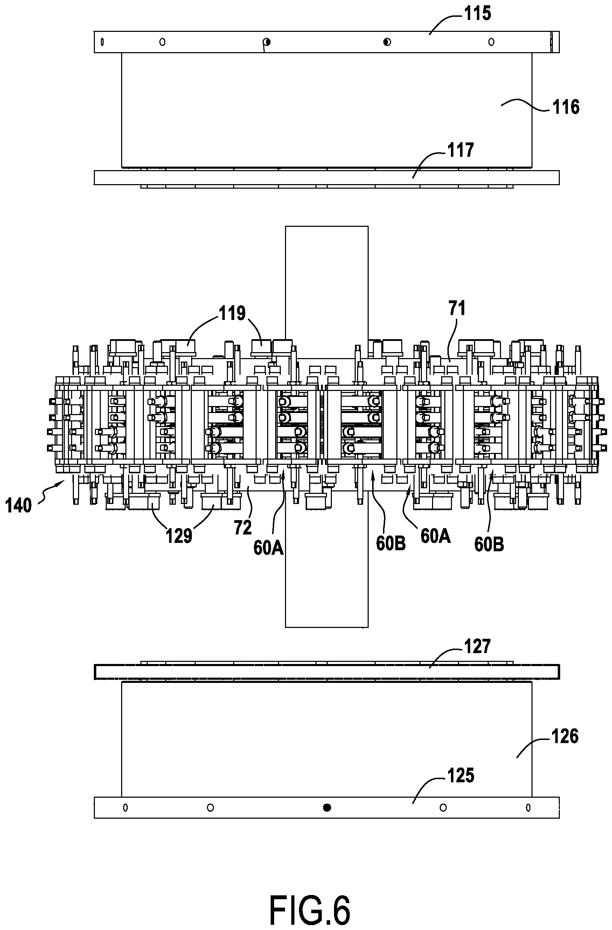

Les figures 5 et 6 montrent des exemples de réalisation où l'ensemble 140 assurant le maintien et de réglage des aimants élémentaires d'une couronne annulaire médiane 130 à quatre couches superposées, telle que celle représentée sur les figures 10 et 11, comprend deux séries d'ensembles de support 60A et 60B disposés de façon alternée, chaque ensemble de support 60A ou 60B comprenant, comme représenté sur les figures 1 à 4, pour un groupe de quatre aimants élémentaires définissant un secteur, un dispositif de support fixe 40 et des première et deuxième fourches associées à chaque aimant élémentaire et munies de leurs vis de réglage radial et vertical. Une couronne supérieure 71 et une couronne inférieure 72 maintiennent en position les supports fixes 40 des différents ensembles de support 60A, 60B.

Les figures 5 et 6 montrent l'ensemble d'une structure aimantée et de ses moyens de maintien et de réglage. Une telle structure aimantée permet d'obtenir un champ homogène à l'angle magique et peut tourner par exemple à une vitesse de 50 Hz. Elle permet de réaliser notamment de l'imagerie médicale sur un petit animal tel qu'une souris.

A titre d'exemple une structure aimantée finale peut présenter des dimensions hors tout d'environ 400 mm de haut et d'environ 400 mm de diamètre, avec un poids total inférieur à 300 kg. Chacune des couronnes externes 110, 120 et la couronne centrale 130 (décrites précédemment en référence aux figures 10 et 11) est constituée d'aimants élémentaires trapézoïdaux aux caractéristiques différentes permettant d'obtenir le champ homogène souhaité, à l'angle magique.

Les aimants élémentaires des couronnes externes 110, 120 sont positionnés et collés entre eux, tandis que les aimants élémentaires de la couronne centrale 130 sont positionnés et réglés radialement et verticalement de façon indépendante au sein des blocs 60A, 60B décrits précédemment.

Chacune des couronnes externes 110, 120 et la couronne centrale 130 sont incorporées dans un support mécanique propre afin de permettre un réglage dans toutes les directions des positions relatives des trois couronnes 110, 120 et 130 entre elles. Par ailleurs, les aimants élémentaires de la couronne centrale 130 sont réglables individuellement dans le sens radial et dans le sens vertical, comme indiqué précédemment en référence aux figures 1 à 4.

Le support mécanique de chaque couronne externe 110, 120 est simple et comprend un cylindre 116, 126 de la hauteur de la couronne et une plaque 115, 125 permettant de fermer l'aimant final à l'angle magique. Chaque plaque 115, 125 présente une ouverture centrale 118, 128 qui permet de réaliser des corrections magnétiques et des mesures de champ et de RMN. Les aimants élémentaires sont assemblés et collés entre eux, puis positionnés et collés dans le support mécanique. On voit par exemple sur les figures 8 et 9 pour la couronne externe inférieure 120, des aimants élémentaires 121 et 122B pouvant être réalisés comme montré sur les figures 10 et 11 et disposés à l'intérieur de l'espace défini par la plaque de fermeture 125 et le cylindre 126. Le cylindre 126 est fixé sur la plaque de fermeture 125 et est également fixé du côté opposé sur une bride 127 à laquelle est fixée par des moyens de fixation 129 la couronne inférieure 72 de maintien en position des supports fixes des différents ensembles de support 60A, 60B de l'ensemble mécanique 140 associé à la couronne centrale 130.

Le support mécanique de la couronne externe supérieure 110, visible sur les figures 5 et 6, est analogue au support mécanique de la couronne externe inférieure 120 représentée sur les figures 8 et 9. On voit ainsi sur les figures 5 et 6 la plaque de fermeture 115 munie de son ouverture centrale 118, le cylindre 116, la bride 117 et les moyens 119 de liaison avec la couronne supérieure 71 de maintien en position des supports fixes des différents ensembles de support 60A, 60B de l'ensemble mécanique 140 associé à la couronne centrale 130.

Les aimants permanents sont très sensibles aux variations de température. On associe donc à la structure aimantée finale, telle que celle représentée sur la figure 5, une enceinte de protection thermique 150 afin d'obtenir la meilleure sensibilité et d'optimiser le fonctionnement.

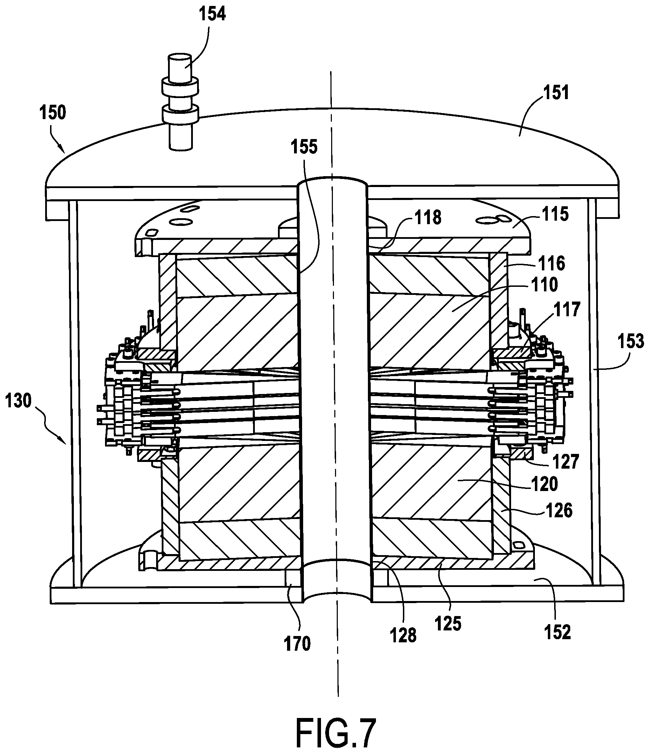

On a représenté sur la figure 7 un exemple d'enceinte de protection thermique 150 qui est à la fois compacte, à bas coût et légère. Un tel exemple d'enceinte de protection thermique 150 comprend un cylindre extérieur 153 qui permet l'isolation de l'aimant par rapport à l'extérieur, une bride inférieure 152 formant plaque de fermeture et assurant l'interface avec une table tournante ou autre dispositif de support, une bride supérieure 151 assurant une fermeture et une étanchéité avec l'adjonction de joints et un cylindre intérieur 155 qui traverse les ouvertures centrales 118, 128 des plaques de fermeture 115, 125 des couronnes externes supérieure et inférieure 110, 120. La bride supérieure 151 est en outre munie de deux robinets 154 pour permettre de faire et de maintenir le vide à l'intérieur de l'enceinte de protection thermique 150. La présence de deux robinets 154 disposés de façon symétrique par rapport à l'axe principal de l'appareil permet d'éviter un balourd supplémentaire. Le cylindre extérieur 153 et le cylindre intérieur 155 sont avantageusement soudés sur la bride inférieure 152. Par ailleurs, une pièce isolante 170 peut être interposée entre la plaque de fermeture 125 de la couronne externe inférieure 120 et la bride inférieure 152 de la protection thermique 150 de manière à minimiser les transferts par conduction, notamment lorsque la structure aimantée est entraînée en rotation sur une table tournante.

On notera que l'invention est définie par les revendications annexées et n'est pas limitée à chacun des différents modes de réalisation décrits qui peuvent se combiner entre eux.

## Revendications

1. Dispositif de création d'un champ magnétique principal d'un système de spectroscopie ou d'imagerie par résonance magnétique comprenant une structure aimantée comprenant des aimants permanents élémentaires (30) destinée à la création dudit champ magnétique principal et un dispositif de maintien et réglage desdits aimants permanents élémentaires (30), ledit système présentant un axe longitudinal par rapport auquel un système de coordonnées cylindriques peut être défini avec une direction longitudinale, une direction radiale et une direction tangentielle, chaque aimant permanent élémentaire (30) présentant des faces principales (31, 32) perpendiculaires audit axe longitudinal et des faces latérales (33, 34) perpendiculaires auxdites faces principales, **caractérisé en ce que** ledit dispositif de maintien et réglage comprend pour chaque aimant permanent élémentaire (30) une première fourche (10) rigide en matériau amagnétique qui pince latéralement de manière fixe l'aimant permanent élémentaire (30) et une deuxième fourche (20) rigide en matériau amagnétique, qui est en prise avec ladite première fourche (10) par un système de glissière (15, 16, 21, 22) orienté selon ladite direction radiale et qui est munie de moyens de réglage radial (23) de la première fourche (10) par rapport à un support fixe (40) auquel est rattachée la deuxième fourche (20) et **en ce que** la deuxième fourche rigide (20) est en outre munie de moyens de réglage (24) par rapport au support fixe (40) dans une direction perpendiculaire aux faces principales dudit aimant permanent élémentaire (30).

2. Dispositif selon la revendication 1, **caractérisé en ce que** chaque aimant permanent élémentaire (30) est fixé par collage dans la première fourche rigide (10).

3. Dispositif selon l'une quelconque des revendications 1 et 2, **caractérisé en ce que** lesdits moyens de réglage radial (23) comprennent une tige filetée dont une extrémité (27) est en prise avec une encoche (17) formée dans une partie arrière de ladite première fourche (10).

4. Dispositif selon l'une quelconque des revendications 1 à 3, **caractérisé en ce que** ledit support fixe (40) est muni de pions (45 à 52) de positionnement des deuxièmes fourches (20) associées aux aimants permanents élémentaires (30) disposés en plusieurs couches superposées selon ledit axe longitudinal.

5. Dispositif selon l'une quelconque des revendications 1 à 4, **caractérisé en ce que** l'ensemble desdits supports fixes (40) associés aux différents aimants permanents élémentaires (30) sont enserrés entre des première et deuxième couronnes de maintien (71, 72).

6. Dispositif selon l'une quelconque des revendications 1 à 5, **caractérisé en ce que** lesdits aimants permanents élémentaires (30) sont répartis en au moins des première et deuxième couches superposées (131, 135 ; 132, 136) selon ledit axe longitudinal.

7. Dispositif selon la revendication 6, **caractérisé en ce que** chaque support fixe (40) est associé à plusieurs aimants permanents élémentaires superposés (30, 30a, 30b, 30c) et coopère avec des rainures (25, 26) ou nervures de guidage formées dans les deuxièmes fourches rigides (20, 20a, 20b, 20c) associées respectivement auxdits aimants permanents élémentaires superposés (30, 30a, 30b, 30c).

8. Dispositif selon la revendication 7, **caractérisé en ce que** chaque support fixe (40) est associé à quatre aimants permanents élémentaires superposés (30, 30a, 30b, 30c) dont les deuxièmes fourches rigides (20, 20a, 20b, 20c) coopèrent avec des moyens de réglage (24, 24a, 24b, 24c) par rapport au support fixe (40) dans une direction perpendiculaire aux faces principales desdits aimants permanents élémentaires (30, 30a, 30b, 30c), ces moyens de réglage (24, 24a, 24b, 24c) étant répartis sur deux côtés opposés dudit support fixe (40).

9. Dispositif selon l'une quelconque des revendications 1 à 8, **caractérisé en ce que** les premières et deuxièmes fourches rigides (10, 20) sont en alliage d'aluminium 7075.

10. Dispositif selon l'une quelconque des revendications 1 à 9, **caractérisé en ce que** les aimants permanents élémentaires (30) ont une forme choisie parmi les parallélépipèdes, les cylindres, les secteurs.

11. Dispositif selon l'une quelconque des revendications 1 à 10, **caractérisé en ce que** la structure aimantée appliquée à un appareil de Résonance Magnétique Nucléaire, induisant dans une zone d'intérêt centrale un champ magnétique homogène orienté selon un axe à l'angle magique par rapport à un axe longitudinal de la structure, comprend des première et deuxième couronnes aimantées (110, 120) disposées de façon symétrique par rapport à un plan qui est perpendiculaire audit axe longitudinal et contient ladite zone d'intérêt centrale, et une structure aimantée annulaire médiane (130) interposée entre les première et deuxième couronnes aimantées (110, 120), également disposée de façon symétrique par rapport audit plan, et divisée en au moins deux tranches selon l'axe longitudinal, les première et deuxième couronnes aimantées (110, 120) ainsi que les diverses tranches de la structure aimantée médiane (130) étant divisées chacune en aimants permanents élémentaires en forme de secteurs..

12. Dispositif selon la revendication 11, **caractérisé en ce que** les aimants permanents élémentaires des première et deuxième couronnes aimantées (110, 120) sont collés entre eux de façon fixe, mais la structure aimantée comprend des moyens de réglage longitudinal entre les première et deuxième couronnes aimantées (110, 120) et la structure aimantée annulaire médiane (130).

13. Procédé de création d'un champ magnétique principal d'un système de spectroscopie ou d'imagerie par résonance magnétique avec maintien et réglage d'aimants permanents élémentaires (30) destinés à la création dudit champ magnétique principal, ledit système de spectroscopie ou d'imagerie par résonance magnétique présentant un axe longitudinal par rapport auquel un système de coordonnées cylindriques peut être défini avec une direction longitudinale, une direction radiale et une direction tangentielle, chaque aimant permanent élémentaire (30) présentant des faces principales perpendiculaires audit axe longitudinal et des faces latérales perpendiculaires auxdites faces principales, **caractérisé en ce qu'**il comprend pour chaque aimant permanent élémentaire (30) les étapes suivantes :
- disposer de manière fixe sur chaque aimant permanent élémentaire (30) une première fourche rigide en matériau amagnétique qui pince latéralement de manière fixe l'aimant permanent élémentaire (30),
- disposer pour chaque aimant permanent élémentaire (30) une deuxième fourche (20) rigide en matériau amagnétique qui est en prise avec ladite première fourche (10) par un système de glissière (15, 16, 21, 22) orienté selon ladite direction radiale
- ajuster radialement la position de la première fourche (10) par rapport à un support fixe (40) auquel est rattachée ladite deuxième fourche (20) et **en ce qu'**il comprend en outre l'étape consistant à ajuster la position de la deuxième fourche (20) par rapport audit support fixe (40) dans une direction perpendiculaire aux faces principales dudit aimant permanent élémentaire (30).

14. Procédé selon la revendication 13, **caractérisé en ce que** l'on associe à un même support fixe (40) plusieurs aimants permanents élémentaires superposés (30, 30a, 30b, 30c) selon ledit axe longitudinal et équipés desdites première et deuxième fourches rigides (10, 20 ; 10a, 20a ; 10b, 20b ; 10c, 20c).

## Patentansprüche

1. Vorrichtung zur Erzeugung eines Hauptmagnetfeldes eines Spektroskopie- oder Bildgebungssystems durch Magnetresonanz, umfassend eine Magnetstruktur, die zur Erzeugung des Hauptmagnetfeldes elementare Dauermagneten (30) und eine Halte- und Einstellungsvorrichtung der elementaren Dauermagneten (30) umfasst, wobei das System eine Längsachse aufweist, in Bezug zu der ein System von zylindrischen Koordinaten mit einer Längsrichtung, einer Radialrichtung und einer Tangentialrichtung definiert werden kann, wobei jeder elementare Dauermagnet (30) Hauptflächen (31, 32) senkrecht auf die Längsachse und Seitenflächen (33, 34) senkrecht auf die Hauptflächen aufweist, **dadurch gekennzeichnet, dass** die Halte- und Einstellungsvorrichtung für jeden elementaren Dauermagneten (30) eine erste starre Gabel (10) aus amagnetischem Material, die den elementaren Dauermagneten (30) seitlich fest einklemmt, und eine zweite starre Gabel (20) aus amagnetischem Material umfasst, die mit der ersten Gabel (10) durch ein Gleitschienensystem (15, 16, 21, 22) in Eingriff ist, das in die Radialrichtung ausgerichtet ist und mit radialen Einstellungsmitteln (23) der ersten Gabel (10) in Bezug zu einem festen Träger (40), an dem die zweite Gabel (20) befestigt ist, versehen ist, und dass die zweite starre Gabel (20) ferner mit Einstellungsmitteln (24) in Bezug zum festen Träger (40) in eine Richtung senkrecht auf die Hauptflächen des elementaren Dauermagneten (30) versehen ist.

2. Vorrichtung gemäß Anspruch 1, **dadurch gekennzeichnet, dass** jeder elementare Dauermagnet (30) durch Kleben in der ersten starren Gabel (10) befestigt ist.

3. Vorrichtung gemäß einem der Ansprüche 1 und 2, **dadurch gekennzeichnet, dass** die radialen Einstellungsmittel (23) eine Gewindestange umfassen, von der ein Ende (27) mit einer Kerbe (17) in Eingriff ist, die in einem hinteren Teil der ersten Gabel (10) ausgebildet ist.

4. Vorrichtung gemäß einem der Ansprüche 1 bis 3, **dadurch gekennzeichnet, dass** der fest Träger (40) mit Stiften (45 bis 52) zur Positionierung der zwei den elementaren Dauermagneten (30) zugeordneten Gabeln (20) versehen ist, die in mehreren übereinander liegenden Schichten entlang der Längsachse angeordnet sind.

5. Vorrichtung gemäß einem der Ansprüche 1 bis 4, **dadurch gekennzeichnet, dass** die Gesamtheit der festen Träger (40), die den verschiedenen elementaren Dauermagneten (30) zugeordnet sind, zwischen ersten und zweiten Haltekränzen (71, 72) eingespannt sind.

6. Vorrichtung gemäß einem der Ansprüche 1 bis 5, **dadurch gekennzeichnet, dass** die elementaren Dauermagneten (30) in mindestens ersten und zweiten übereinander liegenden Schichten (131, 135, 132, 136) entlang der Längsachse verteilt sind.

7. Vorrichtung gemäß Anspruch 6, **dadurch gekennzeichnet, dass** jeder feste Träger (40) mehreren übereinander liegenden elementaren Dauermagneten (30, 30a, 30b, 30c) zugeordnet ist und mit Nuten (25, 26) oder Führungsrillen zusammenwirkt, die in den zweiten starren Gabeln (20, 20a, 20b, 20c) ausgebildet sind, die jeweils den übereinander liegenden elementaren Dauermagneten (30, 30a, 30b, 30c) zugeordnet sind.

8. Vorrichtung gemäß Anspruch 7, **dadurch gekennzeichnet, dass** jeder feste Träger (40) vier übereinander liegenden elementaren Dauermagneten (30, 30a, 30b, 30c) zugeordnet ist, deren zweiten starren Gabeln (20, 20a, 20b, 20c) mit Einstellungsmitteln (24, 24a, 24b, 24c) in Bezug zum festen Träger (40) in eine Richtung senkrecht auf die Hauptflächen der elementaren Dauermagneten (30, 30a, 30b, 30c) zusammenwirken, wobei diese Einstellungsmittel (24, 24a, 24b, 24c) auf zwei gegenüberliegenden Seiten des festen Trägers (40) verteilt sind.

9. Vorrichtung gemäß einem der Ansprüche 1 bis 8, **dadurch gekennzeichnet, dass** die ersten und zweiten starren Gabeln (10, 20) aus Aluminiumlegierung 7075 sind.

10. Vorrichtung gemäß einem der Ansprüche 1 bis 9, **dadurch gekennzeichnet, dass** die elementaren Dauermagneten (30) eine Form haben, die unter den Parallelepipeden, den Zylindern, den Sektoren ausgewählt ist.

11. Vorrichtung gemäß einem der Ansprüche 1 bis 10, **dadurch gekennzeichnet, dass** die Magnetstruktur, die an einem Kernresonanzgerät angewandt wird, wobei in eine zentrale Zone von Interesse ein homogenes Magnetfeld induziert wird, das entlang einer Achse im magischen Winkel in Bezug zu einer Längsachse der Struktur ausgerichtet ist, erste und zweite Magnetkränze (110, 120), die symmetrisch in Bezug zu einer Ebene, die auf die Längsachse senkrecht ist und die zentrale Zone von Interesse enthält, angeordnet sind, und eine mittlere ringförmige Magnetstruktur (130) umfasst, die zwischen den ersten und zweiten Magnetkränzen (110, 120) zwischengefügt ist, ebenfalls symmetrisch zu der Ebene angeordnet ist und in mindestens zwei Abschnitte entlang der Längsachse geteilt ist, wobei der ersten und der zweite Magnetkranz (110, 120) sowie die verschiedenen Abschnitte der mittleren Magnetstruktur (130) jeweils in elementare Dauermagneten in Form von Sektoren unterteilt sind.

12. Vorrichtung gemäß Anspruch 11, **dadurch gekennzeichnet, dass** die elementaren Dauermagneten der ersten und zweiten Magnetkränze (110, 120) miteinander fest verklebt sind, aber die Magnetstruktur Längseinstellungsmittel zwischen den ersten und zweiten Magnetkränzen (110, 120) und der mittleren ringförmigen Magnetstruktur (130) umfasst.

13. Verfahren zur Erzeugung eines Hauptmagnetfeldes eines Spektroskopie- oder Bildgebungssystems durch Magnetresonanz mit Halten und Einstellung von elementaren Dauermagneten (30), die zur Erzeugung des Hauptmagnetfeldes vorgesehen sind, wobei das Spektroskopie- oder Bildgebungssystem durch Magnetresonanz eine Längsachse aufweist, in Bezug zu der ein System von zylindrischen Koordinaten mit einer Längsrichtung, einer Radialrichtung und einer Tangentialrichtung definiert werden kann, wobei jeder elementare Dauermagnet (30) Hauptflächen senkrecht auf die Längsachse und Seitenflächen senkrecht auf die Hauptflächen aufweist, **dadurch gekennzeichnet, dass** es für jeden elementaren Dauermagneten (30) die folgenden Schritte umfasst:
- auf jedem elementaren Dauermagneten (30) festes Anbringen einer ersten starren Gabel aus amagnetischem Material, die den elementaren Dauermagneten (30) seitlich fest einklemmt,
- für jeden elementaren Dauermagneten (30) Anbringen einer zweiten starren Gabel (20) aus amagnetischem Material, die mit der ersten Gabel (10) durch ein Gleitschienensystem (15, 16, 21, 22) in Eingriff ist, das in die Radialrichtung ausgerichtet ist,
- radiales Justieren der ersten Gabel (10) in Bezug zu einem festen Träger (40), an dem die zweite Gabel (20) befestigt ist,
und dass es ferner den Schritt umfasst, der darin besteht, die Position der zweiten Gabel (20) in Bezug zum festen Träger (40) in eine Richtung senkrecht auf die Hauptflächen des elementaren Dauermagneten (30) zu justieren.

14. Verfahren gemäß Anspruch 13, **dadurch gekennzeichnet, dass** einem selben festen Träger (40) mehrere übereinander liegende elementare Dauermagneten (30, 30a, 30b, 30c) entlang der Längsachse, die mit den ersten und zweiten starren Gabeln (10, 20, 10a, 20a, 10b, 20b, 10c, 20c) ausgestattet sind, zugeordnet sind.

## Claims

1. A device for creating a main magnetic field of a spectroscopy or a magnetic resonant imaging system comprising a magnetized structure comprising individual permanent magnets (30) and for the purpose of creating said main magnetic field and a device for maintaining and adjusting said individual permanent magnets (30), said system presenting a longitudinal axis relative to which a system of cylindrical coordinates can be defined with a longitudinal direction, a radial direction, and a tangential direction, each individual permanent magnet (30) presenting main faces (31, 32) perpendicular to said longitudinal axis and lateral faces (33, 34) perpendicular to said main faces, **characterized in that** the maintaining and adjusting device includes, for each individual permanent magnet (30), a first rigid fork (10) of non-magnetic material that clamps the individual permanent magnet (30) laterally in fixed manner, and a second rigid fork (20) of non-magnetic material that engages said first fork (10) by means of a slideway system (15, 16, 21, 22) oriented along said radial direction and that is provided with radial adjustment means (23) for radially adjusting the first fork (10) relative to a stationary support (40) to which the second fork (20) is attached, and wherein the second rigid fork (20) is also provided with adjustment means (24) for adjustment relative to the stationary support (40) in a direction perpendicular to the main faces of said individual permanent magnet (30).

2. A device according to claim 1, **characterized in that** each individual permanent magnet (30) is fastened in the first rigid fork (10) by adhesive bonding.

3. A device according to claim 1 or 2, **characterized in that** said radial adjustment means (23) comprise a threaded rod having one end (27) engaged in a notch (17) formed in a rear portion of said first fork (10).

4. A device according to any one of claims 1 to 3, **characterized in that** said stationary support (40) is provided with pegs (45 to 52) for positioning the second forks (20) associated with the individual permanent magnets (30) that are arranged in a plurality of layers that are superposed along said longitudinal axis.

5. A device according to any one of claims 1 to 4, **characterized in that** all of said stationary supports (40) associated with the various individual permanent magnets (30) are clamped between first and second holder rings (71, 72).

6. A device according to any one of claims 1 to 5, **characterized in that** said individual permanent magnets (30) are arranged in at least first and second layers that are superposed (131, 135 ; 132, 136) along said longitudinal axis.

7. A device according to claim 6, **characterized in that** each stationary support (40) is associated with a plurality of superposed individual permanent magnets and co-operates with guide grooves (25, 26) or splines formed in or on the second rigid forks (20, 20a, 20b, 20c) respectively associated with said superposed individual permanent magnets (30, 30a, 30b, 30c).

8. A device according to claim 7, **characterized in that** each stationary support (40) is associated with four superposed individual permanent magnets (30, 30a, 30b, 30c) having their second rigid forks (20, 20a, 20b, 20c) co-operating with adjustment means (24, 24a, 24b, 24c) for adjustment relative to the stationary support (40) in a direction perpendicular to the main faces of said individual permanent magnets (30, 30a, 30b, 30c), said adjustment means (24, 24a, 24b, 24c) being distributed over two opposite sides of said stationary support (40).

9. A device according to any one of claims 1 to 8, **characterized in that** the first and second rigid forks (10, 20) are made of 7075 aluminum alloy.

10. A device according to any one of claims 1 to 9, **characterized in that** the individual permanent magnets (30) are of a shape selected from rectangular blocks, cylinders, and sectors.

11. A device according to any one of claims 1 to 10, **characterized in that** the magnetized structure applied to a nuclear magnetic resonance apparatus, the structure inducing, in a central zone of interest, a homogeneous magnetic field that is oriented along an axis at the magic angle relative to a longitudinal axis of the structure, comprises first and second magnetized rings (110, 120) arranged symmetrically relative to a plane that is perpendicular to said longitudinal axis and that contains said central zone of interest, and a middle annular magnetized structure (130) interposed between the first and second magnetized rings (110, 120), likewise arranged symmetrically about said plane, and subdivided into at least two slices along the longitudinal axis, the first and second magnetized rings (110, 120) and the various slices of the middle magnetized structure (130) each being subdivided into individual permanent magnets of sector shape.

12. A device according to claim 11, **characterized in that** the individual permanent magnets of the first and second magnetized rings (110, 120) are adhesively bonded to one another in fixed manner, while the magnetized structure includes longitudinal adjustment means between the first and second magnetized rings (110, 120) and the middle annular magnetized structure (130).

13. A method of creating a main magnetic field of a spectroscopy or a magnetic resonant imaging system with individual permanent magnets (30) for creating said main magnetic field being held and adjusted, said spectroscopy or magnetic resonant imaging system presenting a longitudinal axis relative to which a system of cylindrical coordinates can be defined with a longitudinal direction, a radial direction, and a tangential direction, each individual permanent magnet (30) presenting main faces perpendicular to said longitudinal axis and lateral faces perpendicular to said main faces, wherein for each individual permanent magnet (30) it comprises the following steps:
• placing a first rigid fork of non-magnetic material in fixed manner on each individual permanent magnet (30), the fork laterally clamping the individual permanent magnet (30) in fixed manner;
• for each individual permanent magnet (30), arranging a second rigid fork (20) of non-magnetic material that engages said first fork (10) via a slideway system (15, 16, 21, 22) oriented along said radial direction; and
• radially adjusting the position of the first fork (10) relative to a stationary support (40) to which said second fork (20) is attached; and
wherein it further comprises the step consisting in adjusting the position of the second fork (20) relative to said stationary support (40) in a direction perpendicular to the main faces of said individual permanent magnet (30).

14. A method according to claim 13, wherein a given stationary support (40) is associated with a plurality of individual permanent magnets (30, 30a, 30b, 30c) that are superposed along said longitudinal axis and fitted with said first and second rigid forks (10, 20 ; 10a, 20a ; 10b, 20b ; 10c, 20c).
